# EUROPÄISCHE PATENTSCHRIFT

(11) **EP 3 490 272 B1**
(45) Veröffentlichungstag und Bekanntmachung des Hinweises auf die Patenterteilung: **28.12.2022**
(21) Anmeldenummer: 18204016.2
(22) Anmeldetag: 02.11.2018
(51) Int. Cl.: H04R 25/00, H05K 1/14

(54) **HÖRGERÄTECHARGE UND VERFAHREN ZUR HERSTELLUNG EINER HÖRGERÄTECHARGE**
BATCH OF LISTENING DEVICES AND METHOD FOR PRODUCING A BATCH OF LISTENING DEVICES
LOT D'APPAREILS AUDITIVES ET PROCÉDÉ DE FABRICATION D'UN LOT D'APPAREILS AUDITIVES

(30) Priorität: 28.11.2017 DE 102017221332
(43) Veröffentlichungstag der Anmeldung: 29.05.2019
(73) Patentinhaber: Sivantos Pte. Ltd., Singapore 539775 (SG)
(72) Erfinder: GEBHARDT, Volker, 91077 Neunkirchen am Brand (DE); KRAL, Holger, 90766 Fürth (DE); SCHMITT, Christian, 91091 Grossenseebach (DE)
(74) Vertreter: FDST Patentanwälte

(56) Entgegenhaltungen:
- EP-A1- 2 988 530
- EP-A2- 2 495 999
- DE-B3-102008 008 897
- US-A- 5 032 737
- US-A1- 2017 179 103

## Beschreibung

Die Erfindung betrifft eine Hörgerätecharge mit mehreren gleichartigen Hörgeräten. Von diesen gleichartigen Hörgeräten ist ein jedes ausgebildet als ein Hörgerät aufweisend eine Leiterplatine mit zwei Trägersegmenten, welche jeweils eine Trägerschicht aufweisen, an der eine Leiterstruktur anhaftet, und mit einem Verbindungssegment, welches die beiden Trägersegmente miteinander verbindet. Ein solches Hörgerät ist beispielsweise aus der DE 10 2008 008 897 B3 zu entnehmen. Weiterhin betrifft die Erfindung ein Verfahren zur Herstellung einer entsprechenden Hörgerätecharge.

Als Hörgeräte bezeichnet man typischerweise klassische Hörhilfen, die zur Versorgung von Schwerhörenden dienen. Derartige Hörhilfen sind prinzipiell bekannt und zum Beispiel in der EP 2 988 530 A1 oder in der EP 2 495 999 A2 beschrieben.

Im weiteren Sinne bezeichnet dieser Begriff jedoch auch Geräte, die zur Unterstützung von normal hörenden Menschen ausgebildet sind. Solche Hörgeräte werden auch als "Personal Sound Amplification Products" oder "Personal Sound Amplification Devices" (kurz: "PSAD") bezeichnet. Diese sind nicht zur Kompensation von Hörverlusten vorgesehen, sondern werden gezielt zur Unterstützung und Verbesserung des normalen menschlichen Hörvermögens in spezifischen Hörsituationen eingesetzt, z.B. zur Unterstützung von Jägern auf der Jagd oder zur Unterstützung der Tierbeobachtung, um Tierlaute und sonstige von Tieren erzeugte Geräusche besser wahrnehmen zu können, für Sportreporter, um ein verbessertes Sprechen und/oder Sprachverstehen in komplexer Geräuschkulisse zu ermöglichen, für Musiker, um die Belastung des Gehöres zu reduzieren, etc.

Unabhängig vom vorgesehenen Einsatzzweck weisen Hörgeräte typischerweise einen Eingangswandler, eine Signalverarbeitungseinrichtung, welche üblicherweise einen Verstärker umfasst, und einen Ausgangswandler als wesentliche Komponenten auf. Der Eingangswandler ist dabei in der Regel durch einen akusto-elektrischer Wandler ausgebildet, also beispielsweise durch ein Mikrofon, und / oder durch einen elektromagnetischen Empfänger, zum Beispiel eine Induktionsspule. Als Ausgangswandler wird meist ein elektroakustischer Wandler eingesetzt, beispielsweise ein Miniaturlautsprecher (auch als "Hörer" bezeichnet), oder ein elektromechanischer Wandler, zum Beispiel ein Knochenleitungshörer, und die Signalverarbeitungseinrichtung ist in der Regel durch eine auf einer Leiterplatine realisierte elektronische Schaltung realisiert.

Eine Leiterplatine für ein tragbares elektronisches System ist zum Beispiel in der US 2017/0179103 A1 beschrieben.

Ausgehend hiervon liegt der Erfindung die Aufgabe zugrunde eine vorteilhaft ausgebildete Hörgerätecharge sowie ein vorteilhaftes Verfahren zur Herstellung einer Hörgerätecharge anzugeben.

Diese Aufgabe wird erfindungsgemäß gelöst durch eine Hörgerätecharge mit den Merkmalen des Anspruchs 1 sowie durch ein Verfahren mit den Merkmalen des Anspruchs 9. Bevorzugte Weiterbildungen sind in den rückbezogenen Ansprüchen enthalten. Die im Hinblick auf die Hörgerätecharge angeführten Vorteile und bevorzugten Ausgestaltungen sind sinngemäß auch auf das Verfahren übertragbar und umgekehrt.

Die erfindungsgemäße Hörgerätecharge weist mehrere gleichartige Hörgeräte auf, wobei jedes dieser Hörgeräte als maßgefertigtes Hörgerät ausgebildet ist und ein maßgefertigtes Gehäuse mit einem individuell gestalteten Innenraum aufweist, wodurch sich die Gehäuse dieser Hörgeräte hinsichtlich ihrer Gestaltung voneinander unterscheiden. Zudem ist die jeweils zugehörige Leiterplatine von jedem dieser Hörgeräte als eine standardisierte Leiterplatine vorgefertigt und ein jeweils zugehöriges Verbindungssegment wurde vor dem Einsetzen der Leiterplatine in das zugehörige maßgefertigte Gehäuse individuell gebogen und/oder individuell in sich verdreht, so dass die jeweils zugehörige Leiterplatine an den individuell gestalteten Innenraum individuell angepasst ist.

Ein entsprechendes Hörgerät ist dabei bevorzugt als klassische Hörhilfe ausgebildet und zum Beispiel als sogenanntes ITE-Hörgerät (ITE: In-The-Ear), als sogenanntes ITC-Hörgerät (ITC: In-The-Canal), als sogenanntes CIC-Hörgerät (CIC: Complete-In-Canal) oder als sogenanntes IIC-Hörgerät (IIC: Invisible-In-Canal) ausgestaltet.

Hierbei weist das Hörgerät die Leiterplatine oder Leiterplatte auf mit zwei Trägersegmenten sowie mit dem Verbindungssegment, wobei das Verbindungssegment die beiden Trägersegmente miteinander verbindet, insbesondere mechanisch einerseits und elektrisch leitend andererseits. Mit Hilfe dieser Leiterplatine ist zweckdienlicherweise eine Signalverarbeitungseinrichtung realisiert, die beispielsweise einen für ein entsprechendes Hörgerät charakteristischen Verstärker umfasst oder ausbildet. Dabei weist jedes Trägersegment eine Trägerschicht auf, an der eine Leiterstruktur anhaftet und an der typischerweise eine Anzahl elektrischer und/oder elektronischer Bausteine befestigt sind. Diese elektrischen und/oder elektronischen Bausteine sind dann typischerweise über die Leiterstrukturen auf den Trägerschichten der Trägersegmente und in einigen Fällen auch über die Verbindungssegmente zur Ausbildung einer elektronischen Schaltung elektrisch leitend miteinander verbunden und dementsprechend weist das Verbindungssegment bevorzugt eine Anzahl elektrischer Leitungen oder eine Leiterstruktur auf, sodass das Verbindungssegment die Trägersegmente nicht nur mechanisch sondern insbesondere zudem elektrisch leitend miteinander verbindet. Das Verbindungssegment ist somit in jedem Fall Teil der Leiterplatine.

Außerdem ist das Verbindungssegment biegbar und verdrehbar, also in sich verdrehbar oder verdrillbar, ausgestaltet, sodass die Leiterplatine zumindest abschnittsweise oder segmentweise und bevorzugt nur abschnittsweise oder segmentweise flexibel ausgestaltet oder als eine Art faltbare Leiterplatine ausgebildet ist. Die Trägersegmente sind hingegen bevorzugt relativ starr ausgestaltet und somit im Wesentlichen nicht biegbar oder verdrillbar.

Die Herstellung einer solchen Leiterplatine erfolgt dabei beispielsweise durch eine geeignete Kombination oder eine Zusammenfügung einer oder mehrerer starrer Schichten, z.B. aus FR4, und einer oder mehrerer flexibler Schichten, z.B. aus Polyimid. Im vorgesehenen Bereich des Verbindungssegments oder in den vorgesehenen Bereichen der Verbindungssegmente wird die starre Schicht oder werden die starren Schichten dann bevorzugt im Zuge der weitergehenden Leiterplatinenherstellung durch eine Tiefenfräsung entfernt. Dadurch ensteht eine Leiterplatine oder Leiterplatte mit starren die Trägersegmente ausbildenden Bereichen, die durch flexible die Verbindungselemente ausbildende Bereiche verbunden sind.

Infolgedessen lassen sich die Trägersegmente zumindest in begrenztem Umfang frei relativ zueinander anordnen und relativ zueinander ausrichten. Dies wiederum ermöglicht eine individuelle Anpassung der Form der Leiterplatine mit ihren Trägersegmenten und dem Verbindungssegment und somit auch eine Anpassung der Form der Leiterplatine an einen gegebenen Bauraum oder an einen vorgesehenen Bauraum in einem Gehäuse des Hörgerätes.

Durch die Anpassbarkeit der Form der Leiterplatine wird außerdem ein vorteilhaftes Verfahren zur Herstellung von Hörgeräten der Hörgerätecharge ermöglicht und auch umgesetzt. Bei diesem erfolgt eine Herstellung von Hörgeräten derart, dass eine zuvor genannte Leiterplatine vorgefertigt wird, nachfolgend oder später das Verbindungssegment vor dem Einsetzen der Leiterplatine in das Gehäuse des Hörgerätes gebogen und/oder verdreht oder in sich verdreht wird, um die Leiterplatine in einen vorgesehenen Einbau-Zustand zu versetzen und um eine vorgesehene oder vorgegebene Form der Leiterplatine zu realisieren, und dass schließlich die so geformte Leiterplatine in das Gehäuse eingesetzt wird. Das Biegen und/oder Verdrehen des Verbindungssegments erfolgt dabei bevorzugt unmittelbar vor dem Einsetzen der Leiterplatine in das Gehäuse und bevorzugt nicht im Rahmen der Vorfertigung der Leiterplatine. Alternativ erfolgt das Verbiegen und/oder Verdrehen quasi während dem Einsetzen der Leiterplatine in das Gehäuse, indem beispielsweise zunächst eines der Trägersegmente in den Innenraum des Gehäuses eingeführt wird und nachfolgend das andere Trägersegment quasi durch Verbiegen und/oder Verdrehen des Verbindungssegments in den Innenraum des Gehäuses nachgeführt wird.

Weiter wird das Verfahren genutzt, um maßgefertigte oder individuell angepasste Hörgeräte zu fertigen. Bei diesen maßgefertigten oder individuell angepassten Hörgeräten sind dann die Gehäuse individuell ausgestaltet und weisen eine jeweils an ein Ohr und insbesondere einen Gehörgang eines Nutzers oder Trägers angepasste äußere Form auf. Dabei weist ein entsprechendes Gehäuse beispielsweise eine Gehäuseschale und eine Faceplate auf oder besteht aus genau diesen zwei Teilen. Die Faceplate ist hierbei bevorzugt als eine standardisierte Faceplate ausgestaltet und somit gleichartig bei allen Hörgeräten einer Hörgerätecharge oder Hörgeräteserie mit individuell angepassten Hörgeräten. In diesem Fall unterscheiden sich die individuell ausgestalteten, individuell angepassten oder maßgefertigten Gehäuse hinsichtlich der Ausgestaltung oder Form der Gehäuseschalen, die zweckdienlicherweise an ein Ohr und insbesondere einen Gehörgang eines Nutzers oder Trägers individuell angepasst sind.

Als Folge dieser individuellen Anpassung insbesondere der äußeren Form eines entsprechenden maßgefertigten Gehäuses ist dann auch der Innenraum im entsprechenden Gehäuse, also der nutzbare Bauraum, in dem auch die Leiterplatine anzuordnen ist, individuell gestaltet, weswegen die Leiterplatine individuell geformt in den Bauraum eingesetzt wird, wobei das Verbindungssegment der Leiterplatine individuell gebogen und/oder individuell verdreht oder in sich verdreht wird. Die Leiterplatine selbst ist dabei jedoch als standardisierte Baueinheit vorgefertigt und wird lediglich zur Anpassung an den individuellen Innenraum oder Bauraum des zugehörigen Gehäuses des jeweiligen Hörgerätes durch ein individuelles Verbiegen und/oder individuelles Verdrehen des Verbindungssegments individualisiert.

Auf diese Weise wird dann ein Hörgerät hergestellt, welches als das maßgefertigte Hörgerät ausgebildet ist und das maßgefertigte Gehäuse mit dem individuell gestalteten Innenraum sowie die Leiterplatine aufweist, wobei die Leiterplatine als eine standardisierte Leiterplatine ausgebildet ist. Das heißt, dass sich die Leiterplatinen von zwei fertiggestellten, maßgefertigten Hörgeräten lediglich hinsichtlich der Verbiegung und/oder der Verdrehung des Verbindungssegments unterscheiden. Da dann aber das jeweilige Verbindungssegment vor dem Einsetzen der jeweiligen Leiterplatine in das zugehörige maßgefertigte Gehäuse individuell gebogen und/oder individuell in sich verdreht wurde, ist die jeweilige Leiterplatine an den individuell gestalteten Innenraum individuell angepasst. Als Folge ist dann auch das jeweilige Hörgerät individualisiert oder maßgefertigt.

Weist ein solches Hörgerät weiter ein Gehäuse mit einer Faceplate und insbesondere mit einer standardisierten Faceplate auf, so ist bevorzugt eines der zwei Trägersegmente der Leiterplatine an dieser Faceplate befestigt.

Durch die zuvor beschriebene Individualisierung weist dann die Hörgerätecharge die mehrere gleichartige Hörgeräte auf, wobei jedes dieser Hörgeräte als maßgefertigtes Hörgerät ausgebildet ist, bei dem das jeweils zugehörige Verbindungssegment vor dem Einsetzen der Leiterplatine in das zugehörige maßgefertigte Gehäuse individuell gebogen und/oder individuell in sich verdreht wurde, so dass die jeweils zugehörige Leiterplatine an den individuell gestalteten Innenraum individuell angepasst ist.

Das heißt, dass sich die maßgefertigten Hörgeräte der Hörgerätecharge oder Hörgeräteserie im fertiggestellten Zustand bevorzugt lediglich hinsichtlich der Gestaltung des Gehäuses und hinsichtlich der Verbiegung und/oder der Verdrehung des Verbindungssegments unterscheiden. Dagegen sind die in den Hörgeräten realisierten und/oder freigeschalteten Funktionen bei allen maßgefertigten Hörgeräten der Hörgerätecharge oder Hörgeräteserie bevorzugt gleich.

Einer alternativen Ausführungsvariante entsprechend unterscheiden sich die maßgefertigten Hörgeräte der Hörgerätecharge oder Hörgeräteserie im fertiggestellten Zustand zusätzlich hinsichtlich der Position und/oder der Ausrichtung der Leiterplatine innerhalb des Gehäuses und zwar insbesondere bezogen auf die Position und/oder die Ausrichtung der Faceplate, sofern vorhanden.

Je nach Anwendungsfall wird weiter im Zuge des Herstellungsverfahrens, also im Zuge der Herstellung eines Hörgerätes, eine sich verfestigende Masse, beispielsweise eine Abschirmmasse, aufgetragen. Die Auftragung erfolgt dabei bevorzugt, nachdem die Leiterplatine für ein Einsetzen in das Gehäuse geformt wurde und somit insbesondere nachdem das Verbindungssegment verbogen und/oder verdreht oder in sich verdreht wurde. Die sich verfestigende Masse dient dann in einigen Fällen dazu oder unter anderem auch dazu, die Form der Leiterplatine zu fixieren, also insbesondere die Biegestellung und/oder die Verdrehstellung des Verbindungssegments.

Das hier vorgestellte Konzept lässt sich dabei ohne Weiteres auch auf Leiterplatinen mit mehr als zwei Trägersegmenten und/oder mehr als einem Verbindungssegment übertragen.

Desweiteren wird die Leiterplatine, wie bereits zuvor erwähnt, bevorzugt vorgefertigt und ist zudem bevorzugt als standardisierte Baugruppe ausgebildet. Davon unabhängig sind die beiden Trägersegmente im ausgestreckten, ausgeklappten oder ausgefalteten Zustand, also wenn das Verbindungssegment unverbogen und unverdreht ist, typischerweise entlang einer Verbindungsachse gesehen nebeneinander angeordnet und über das dazwischen liegende Verbindungselement miteinander verbunden. In diesem Zustand sind die entsprechenden Trägerelemente dann über das dazwischen liegende Verbindungselement um die Verbindungsachse gegeneinander verdrehbar, wobei dem Verbindungselement dabei quasi eine Torsion aufgeprägt wird. Alternativ oder zusätzlich dazu ist das Verbindungselement biegbar, insbesondere um eine Achse quer zur Verbindungsachse, wodurch die Leiterplatine quasi faltbar ist.

In vielen Fällen weisen die beiden Trägersegmente im ausgestreckten Zustand dabei quer zur Verbindungsachse gesehen eine größere Ausdehnung auf als das zwischen den beiden Trägersegmenten angeordnete Verbindungssegment. Hierbei entspricht die Ausdehnung des Verbindungssegments quer zur Verbindungsachse bevorzugt weniger als 70 %, weiter bevorzugt weniger als 50 % und insbesondere weniger als 30 % der Ausdehnung eines der Trägersegmente oder beider Trägerelemente quer zur Verbindungsachse. Bevorzugt entspricht die Ausdehnung des Verbindungssegments quer zur Verbindungsachse weniger als 60 % und insbesondere weniger als 40% der Ausdehnung eines der Trägersegmente quer zur Verbindungsachse.

Weiterhin ist das Verbindungssegment bevorzugt derart ausgestaltet, dass die beiden Trägersegmente ausgehend von dem zuvor genannten ausgestreckten Zustand durch Verdrillung des Verbindungssegments um die Verbindungsachse gegeneinander verdrehbar sind und zwar vorzugsweise um einen Winkel >30°, weiter bevorzugt >60° und insbesondere >90° oder sogar >180°. Der maximal mögliche Verdrillwinkel hängt hierbei typischerweise von der Breite und der Länge des Verbindungssegments ab. Diese hängt wiederum üblicherweise von der vorgesehenen Einbauposition ab. Generell ist aber eine möglichst hohe Verdrillbarkeit wünschenswert.

Um eine Verdrillbarkeit und Biegsamkeit insbesondere in verschiedene Richtungen zu ermöglichen, ist es darüber hinaus von Vorteil, wenn das Verbindungssegment nicht gerade, sondern s-förmig oder meanderförmig ausgestaltet ist. Entlang eines s-förmigen oder meanderförmigen Verbindungssegments ergäben sich zudem automatisch Abschnitte mit verschiedenen Biegevorzugsrichtungen.

Die Trägersegmente schließlich tragen typischerweise eine Anzahl elektrischer und/oder elektronischer Bausteine, wobei diese, wie bereits zuvor dargelegt, zusammen mit der Leiterplatine, also insbesondere auch zusammen mit dem Verbindungssegment, typischerweise eine Signalverarbeitungseinrichtung ausbilden. Bevorzugt ist dabei zumindest ein elektronischer Baustein als integrierter Schaltkreis (IC) ausgebildet, mit dessen Hilfe eine Verarbeitung von elektrischen Signalen ermöglicht ist.

Außerdem ist es zweckdienlich, wenn zumindest eines der Trägersegmente eine Antenne für Radiowellen trägt. In einigen Ausführungsvarianten ist eine solche Antenne dabei derart gestaltet, dass diese vom entsprechenden Trägersegment absteht. Alternativ ist eine solche Antenne durch Leiterstrukturen auf einem der Trägersegmente und/oder auf beiden Trägersegmenten ausgebildet.

Ausführungsbeispiele von Hörgeräten werden nachfolgend anhand einer schematischen Zeichnung näher erläutert. Darin zeigen:
- FIG 1: in einer Aufsicht eine erste Ausführung einer Leiterplatine in einem ausgestreckten Zustand,
- FIG 2: in einer Schnittdarstellung eine erste Ausführung eines Hörgerätes mit einem ersten maßgefertigten Gehäuse und der ersten Ausführung der Leiterplatine in einem ersten Einbau-Zustand,
- FIG 3: in einer Schnittdarstellung eine zweite Ausführung des Hörgerätes mit einem zweiten maßgefertigten Gehäuse und der ersten Ausführung der Leiterplatine in einem zweiten Einbau-Zustand,
- FIG 4: in einer Schnittdarstellung eine dritte Ausführung des Hörgerätes mit einem dritten maßgefertigten Gehäuse und der ersten Ausführung der Leiterplatine in einem dritten Einbau-Zustand,
- FIG 5: in einer Seitenansicht eine zweite Ausführung der Leiterplatine in einem Einbau-Zustand,
- FIG 6: in einer Aufsicht eine dritte Ausführung einer Leiterplatine in einem ausgestreckten Zustand,
- FIG 7: in einer Schnittdarstellung eine vierte Ausführung des Hörgerätes mit einem vierten maßgefertigten Gehäuse und einer vierten Ausführung einer Leiterplatine in einem vierten Einbau-Zustand sowie
- FIG 8: in einer Schnittdarstellung eine fünfte Ausführung des Hörgerätes mit einem fünften maßgefertigten Gehäuse und der vierten Ausführung der Leiterplatine in einem fünften Einbau-Zustand.

Einander entsprechende Teile sind in allen Figuren jeweils mit den gleichen Bezugszeichen versehen.

Ein nachfolgend exemplarisch beschriebenes Hörgerät 2 ist bevorzugt als klassische Hörhilfe ausgebildet und zum Beispiel als sogenanntes ITC-Hörgerät (ITC: In-The-Canal) ausgestaltet.

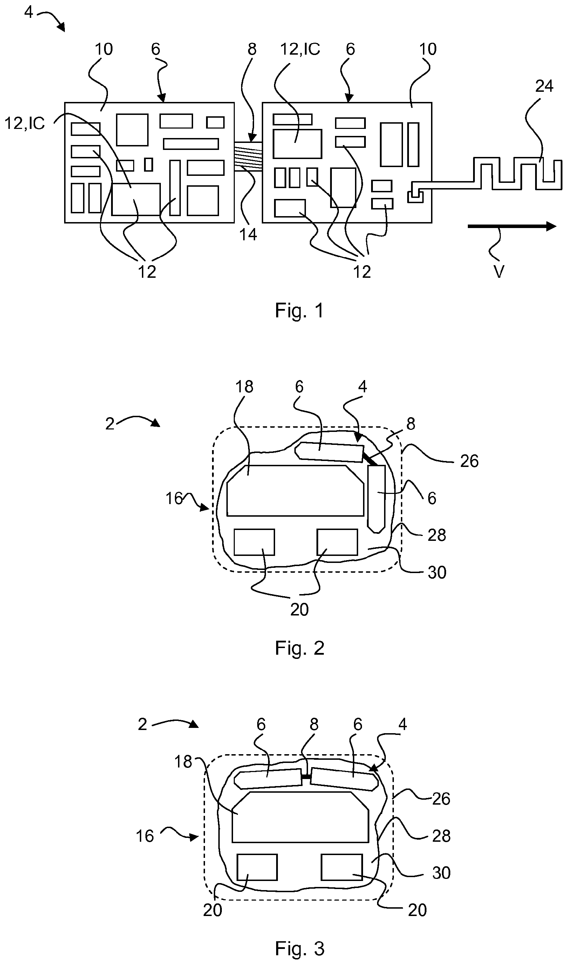

Hierbei weist das Hörgerät 2 eine Leiterplatine 4 auf mit zwei Trägersegmenten 6 sowie mit einem Verbindungssegment 8, wobei das Verbindungssegment 8 die beiden Trägersegmente 6 miteinander verbindet. Jene Leiterplatine 4 wird typischerweise vorgefertigt und ist in Fig. 1 in einer ersten Ausführungsvariante und in einem ausgestreckten Zustand dargestellt. In diesem ausgestreckten Zustand sind die zwei Trägersegmenten 6 entlang einer Verbindungsachse V gesehen nebeneinander angeordnet, wobei das Verbindungssegment 8 zwischen den beiden Trägersegmenten 6 positioniert ist. Dabei weist jedes Trägersegment 6 eine Trägerschicht 10 auf, an der eine nicht dargestellte Leiterstruktur anhaftet und an der typischerweise eine Anzahl elektrischer und/oder elektronischer Bausteine 12 befestigt sind, die durch die Leiterstruktur miteinander verbunden sind.

Mit Hilfe der Leiterplatine 4 und den elektrischen und/oder elektronischen Bausteinen 12 ist dann eine elektronische Schaltung realisiert, die als Signalverarbeitungseinrichtung dient und typischerweise einen für ein entsprechendes Hörgerät 2 charakteristischen Verstärker umfasst. Teil dieser elektronischen Schaltung sind dabei auch Leiter 14 oder Leiterstrukturen, die Bestandteil des Verbindungssegments 8 sind und die die beiden Trägersegmente 6 elektrisch leitfähig miteinander verbinden.

Außerdem ist das Verbindungssegment 8 biegbar und verdrehbar, also insbesondere in sich verdrehbar oder verdrillbar, ausgestaltet, sodass die Leiterplatine 4 abschnittsweise oder segmentweise flexibel ausgestaltet ist und die Form der Leiterplatine 4 angepasst werden kann. Die Trägersegmente 6 sind dagegen relativ starr ausgestaltet und dementsprechend nicht flexibel. Im ausgestreckten Zustand ist das Verbindungssegment 8 dabei noch unverbogen und unverdreht. Ausgehend von diesem Zustand sind die entsprechenden Trägerelemente 6 dann über das dazwischen liegende Verbindungselement 8 um die Verbindungsachse V gegeneinander verdrehbar, wobei dem Verbindungselement 8 dabei quasi eine Torsion aufgeprägt wird. Alternativ oder zusätzlich dazu ist das Verbindungselement 8 biegbar, insbesondere um eine Achse quer zur Verbindungsachse V, wodurch die Leiterplatine 4 quasi faltbar ist. Durch die Anpassbarkeit der Form der Leiterplatine 4 wird dann ein vorteilhaftes Verfahren zur Herstellung einer Charge von Hörgeräten 2 ermöglicht und auch umgesetzt.

Bei diesem erfolgt eine Herstellung von Hörgeräten 2 derart, dass eine zuvor beschriebene Leiterplatine 4 zunächst vorgefertigt wird, später das Verbindungssegment 8 vor dem Einsetzen der Leiterplatine 4 in ein Gehäuse 16 des Hörgerätes 2 gebogen und/oder in sich verdreht wird, um die Leiterplatine 4 in einen vorgesehenen Einbau-Zustand zu versetzen und eine vorgesehene oder vorgegebene Form der Leiterplatine 4 zu realisieren, und dass schließlich die so geformte Leiterplatine 4 in das Gehäuse 16 eingesetzt wird. Das Biegen und/oder Verdrehen des Verbindungssegments 8 erfolgt dabei bevorzugt unmittelbar vordem Einsetzen der Leiterplatine 4 in das Gehäuse 16 und bevorzugt nicht im Rahmen der Vorfertigung der Leiterplatine 4.

Ein solches Verfahren wird genutzt, um maßgefertigte oder individuell angepasste Hörgeräte 2 zu fertigen. Hierbei sind dann bevorzugt die Gehäuse 16 der Hörgeräte 2 individuell ausgestaltet und weisen eine individuell ausgestaltete äußere Form sowie einen individuell ausgestalteten Bau-raum oder Innenraum 30 auf. Drei Beispiele für solche individuell angepassten Hörgeräte 2 sind in Fig. 2 bis Fig. 4 angedeutet.

Die übrigen Bauteile oder Baugruppen, wie zum Beispiel eine Batterie und zwei Mikrofone 20, sind dagegen als standardisierte Bauteile oder Baugruppen ausgestaltet. Auch die Leiterplatine 4 ist dabei zumindest als standardisierte Baugruppe vorgefertigt und wird lediglich dahingehend individualisiert, dass die Leiterplatine 4 individuell geformt und dadurch an den individuell ausgestalteten Bauraum oder Innenraum 30 angepasst wird, wobei das Verbindungssegment 8 der Leiterplatine 4 individuell gebogen und/oder individuell in sich verdreht wird. In Folge dessen sind in Fig. 2 bis Fig. 4 drei unterschiedliche Einbau-Zustande der Leiterplatine 4 wiedergegeben, in denen Leiterplatine 4 jeweils eine individuelle Form hat. Für eine einfachere Darstellung sind lediglich unterschiedliche Biegestellungen gezeigt und es wurde auf eine Darstellung unterschiedlicher Verdrehstellungen des Verbindungssegments 8 verzichtet.

Die maßgefertigten Hörgeräte 2 gemäß Fig. 2 bis Fig. 4 weisen somit also bevorzugt lediglich individualisierte Gehäuse 16 sowie individuell gebogene und/oder individuell in sich verdrehte Verbindungssegmente 8 auf und sind ansonsten gleich. Sie bilden zusammen eine Hörgerätecharge oder Hörgeräteserie von gleichartigen aber maßgefertigten Hörgeräten 2, bei denen stets die gleichen Funktionen realisiert und/oder freigeschaltet sind. Sie unterscheiden sich daher nicht hinsichtlich der Signalverarbeitung in der Signalverarbeitungseinrichtung.

Die individualisierten Gehäuse 16 wiederum weisen gemäß einer Ausführungsvariante jeweils eine maßgefertigte Gehäuseschale 28 sowie eine standardisierte Faceplate 26 auf. In Fig. 2 bis Fig. 4 sind Schnittdarstellungen wiedergegeben, bei denen die Schnittebene, die der Zeichenebene entspricht, parallel zur Faceplate 26 liegt. Die Faceplate 26 liegt dann außerhalb der Zeichenebene und ist durch einen gestrichelten Rahmen angedeutet.

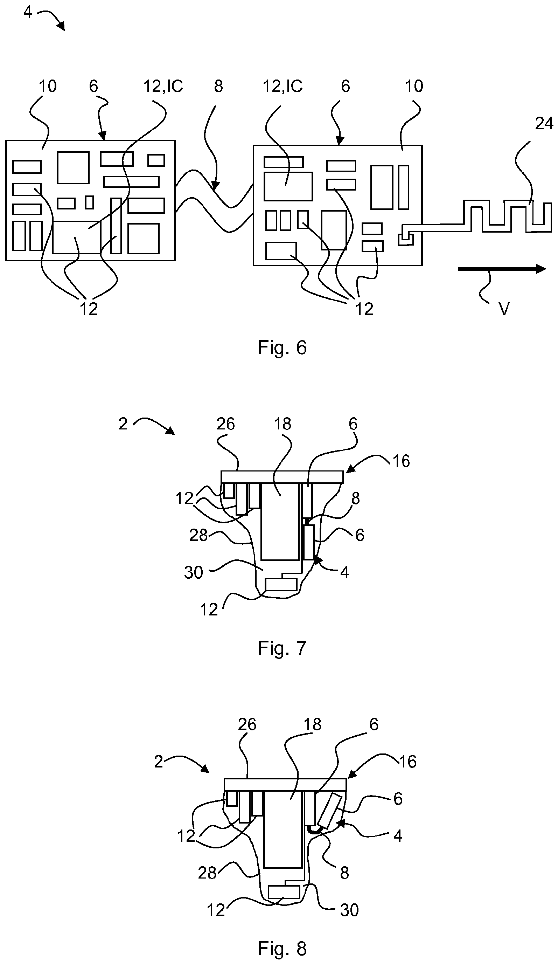

Zwei weitere Beispiele für maßgefertigte Hörgeräte 2 sind in Fig. 7 und Fig. 8 gezeigt. Hier ist die Schnittebene der Schnittdarstellungen senkrecht zur Faceplate 26 ausgerichtet.

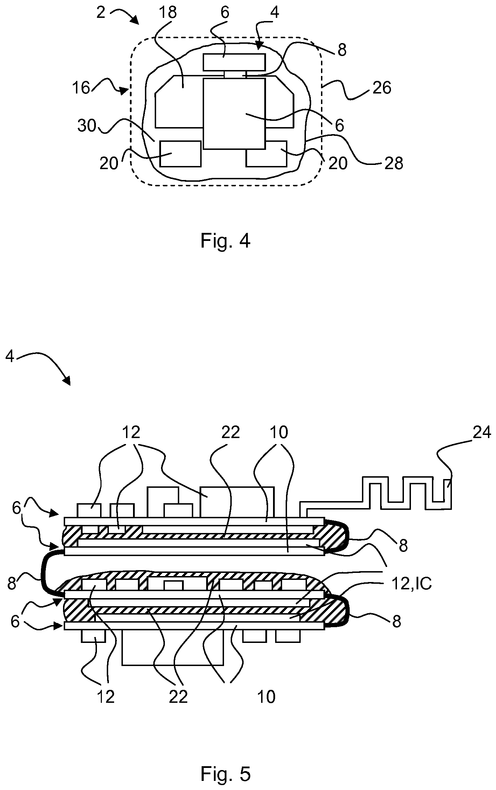

Je nach Anwendungsfall wird weiter im Zuge des Herstellungsverfahrens, also im Zuge der Herstellung eines Hörgerätes 2, eine sich verfestigende Masse, beispielsweise eine Abschirmmasse 22, auf die Leiterplatine 4 aufgetragen, insbesondere um einzelne elektrische oder elektronische Bausteine abzuschirmen, mitunter auch gegeneinander. Die Auftragung erfolgt dabei bevorzugt, nachdem die Leiterplatine 4 für ein Einsetzen in das Gehäuse 16 geformt wurde und somit insbesondere nachdem das Verbindungssegment 8 verbogen und/oder in sich verdreht wurde. Ein entsprechendes Ausführungsbeispiel ist in Fig. 5 wiedergegeben.

Hier weist die Leiterplatine 4 vier Trägersegmente 6 und drei Verbindungssegmente 8 auf. Die Abschirmmasse 22 dient dabei zudem bevorzugt auch dazu, die Form der Leiterplatine 4 zumindest teilweise zu fixieren, also im Ausführungsbeispiel die Biegestellung und/oder die Verdrehstellung der Verbindungssegmente 8 auf der rechten Seite in Fig. 5.

Die Trägersegmente 6 tragen im Ausführungsbeispiel gemäß Fig. 5 wiederum eine Anzahl elektrischer und/oder elektronischer Bausteine 12, wobei diese, wie bereits zuvor dargelegt, zusammen mit der Leiterplatine 4, also insbesondere auch zusammen mit den Verbindungssegmenten 8, typischerweise eine Signalverarbeitungseinrichtung ausbilden. Bevorzugt ist dabei zumindest ein elektronischer Baustein 12 als integrierter Schaltkreis (IC) ausgebildet, mit dessen Hilfe eine Verarbeitung von elektrischen Signalen ermöglicht ist.

Außerdem trägt eines der Trägersegmente 6 eine Antenne 24 für Radiowellen. Diese ist dabei derart gestaltet, dass sie vom entsprechenden Trägersegment absteht. Alternativ ist eine solche Antenne 24 durch Leiterstrukturen auf einem der Trägersegmente 6 und/oder auf Trägersegmenten 6 ausgebildet.

In Fig. 6 ist schließlich eine abgewandelte Ausführungsvariante der Leiterplatine 4 gemäß Fig. 1 abgebildet und hierbei wiederum in einem ausgestreckten Zustand dargestellt. Im Gegensatz zur Ausführungsvariante gemäß Fig. 1 ist das Verbindungssegment 8 hier nicht als gerades Verbindungssegment 8 ausgebildet, sondern als s-förmiges Verbindungssegment 8.

Die Erfindung ist nicht auf das vorstehend beschriebene Ausführungsbeispiel beschränkt. Vielmehr können auch andere Varianten vom Fachmann hieraus abgeleitet werden, ohne den in den Ansprüchen definierten Gegenstand der Erfindung zu verlas-

### Bezugszeichenliste

- 2: Hörgerät
- 4: Leiterplatine
- 6: Trägersegment
- 8: Verbindungssegment
- 10: Trägerschicht
- 12: elektronischer Baustein
- 14: Leiter
- 16: Gehäuse
- 18: Batterie
- 20: Mikrofon
- 22: Abschirmmasse
- 24: Antenne
- 26: Faceplate
- 28: Gehäuseschale
- 30: Innenraum
- V: Verbindungsachse
- IC: integrierter Schaltkreis

## Patentansprüche

1. Hörgerätecharge aufweisend mehrere gleichartige Hörgeräte (2), wobei jedes dieser Hörgeräte (2) eine Leiterplatine (4) mit zwei Trägersegmenten (6) aufweist, welche jeweils eine Trägerschicht (10) aufweisen, an der eine Leiterstruktur anhaftet, und wobei jedes dieser Hörgeräte (2) ein Verbindungssegment (8) aufweist, welches die beiden Trägersegmente (6) miteinander verbindet, wobei das Verbindungssegment (8) biegbar und verdrehbar ausgestaltet ist,
**dadurch gekennzeichnet,**
**dass** die Hörgerätecharge aufweist
- eine erste Ausführung des Hörgerätes (2) mit einem ersten maßgefertigten Gehäuse und einer ersten Ausführung der Leiterplatine in einem ersten Einbau-Zustand,
- eine zweite Ausführung des Hörgerätes mit einem zweiten maßgefertigten Gehäuse und der ersten Ausführung der Leiterplatine in einem zweiten Einbau-Zustand,
- eine dritte Ausführung des Hörgerätes mit einem dritten maßgefertigten Gehäuse und der ersten Ausführung der Leiterplatine in einem dritten Einbau-Zustand, wobei
das jeweilige Hörgerät (2) als maßgefertigtes Hörgerät (2) ausgebildet ist und ein maßgefertigtes Gehäuse (16) mit einer jeweils an ein Ohr eines Trägers angepasste äußere Form sowie mit einem als Folge der an das Ohr des Trägers angepassten äußeren Form individuell gestalteten Innenraum sowie die jeweilige Leiterplatine (4) aufweist, wobei das jeweilige Verbindungssegment (8) der jeweiligen Leiterplatine (4) individuell gebogen und/oder individuell in sich verdreht ist, so dass die jeweilige Leiterplatine (4) an den individuell gestalteten Innenraum individuell angepasst ist, und wobei die Leiterplatinen (4) als standardisierte Leiterplatinen (4) ausgebildet sind, so dass die Leiterplatinen (4) von zwei maßgefertigten Hörgeräten (2) sich lediglich hinsichtlich der Verbiegung und/oder Verdrehung des jeweiligen Verbindungssegments (8) unterscheiden.

2. Hörgerätecharge nach Anspruch 1,
wobei jedes der Hörgeräte (2) **dadurch gekennzeichnet ist,**
**dass** das Verbindungssegment (8) individuell in sich verdreht ist.

3. Hörgerätecharge nach Anspruch 2,
wobei jedes der Hörgeräte (2) **dadurch gekennzeichnet ist,**
**dass** die beiden Trägersegmente (6) im ausgestreckten Zustand der Leiterplatine (4) entlang einer Verbindungsachse (V) gesehen nebeneinander angeordnet sind und dass die beiden Trägersegmente (6) über das dazwischenliegende Verbindungssegment (8) um die Verbindungsachse (V) gegeneinander verdrehbar sind.

4. Hörgerätecharge nach Anspruch 2 oder 3,
wobei jedes der Hörgeräte (2) **dadurch gekennzeichnet ist,**
**dass** die beiden Trägersegmente (6) im ausgestreckten Zustand der Leiterplatine (4) entlang einer Verbindungsachse (V) gesehen nebeneinander angeordnet sind und dass die beiden Trägersegmente quer zur Verbindungsachse (V) gesehen eine größere Ausdehnung aufweisen als das zwischen den beiden Trägersegmenten (6) angeordnete Verbindungssegment (6).

5. Hörgerätecharge nach Anspruch 4,
wobei jedes der Hörgeräte (2) **dadurch gekennzeichnet ist,**
**dass** die Ausdehnung des Verbindungssegments (8) quer zur Verbindungsachse (V) weniger als 60 % der Ausdehnung eines der Trägersegmente (6) quer zur Verbindungsachse (V) entspricht.

6. Hörgerätecharge nach einem der Ansprüche 2 bis 5,
wobei jedes der Hörgeräte (2) **dadurch gekennzeichnet ist,**
**dass** die Trägersegmente (6) elektronische Bausteine (12) tragen.

7. Hörgerätecharge nach einem der Ansprüche 2 bis 6,
wobei jedes der Hörgeräte (2) **dadurch gekennzeichnet ist,**
**dass** eines der Trägersegmente (6) eine Antenne (24) für Radiowellen trägt, die vom Trägersegment (6) absteht.

8. Hörgerätecharge nach einem der Ansprüche 2 bis 7,
wobei jedes der Hörgeräte (2) **dadurch gekennzeichnet ist,**
**dass** eines der zwei Trägersegmente (6) der Leiterplatine (4) an einer Faceplate (26) befestigt ist.

9. Verfahren zur Herstellung einer Hörgerätecharge nach einem der vorherigen Ansprüche,
wobei jedes der Hörgeräte (2) dadurch hergestellt wird,
dass das Verbindungssegment (8) vor oder während dem Einsetzen der Leiterplatine (4) in das maßgefertigte Gehäuse (16) individuell individuell verbogen und/oder in sich verdreht wird, um die Leiterplatine (4) an den individuell gestalteten Innenraum individuell anzupassen.

10. Verfahren nach Anspruch 9,
wobei jedes der Hörgeräte (2) dadurch hergestellt wird,
dass auf die Leiterplatine (4), nachdem diese in sich verdreht wurde, zumindest in einem Abschnitt eine Abschirmmasse (22) aufgetragen wird, die die Form der Leiterplatine (4) fixiert.

## Claims

1. Hearing device batch having a plurality of hearing devices (2) of the same kind, each of said hearing devices (2) having a printed circuit board (4) with two carrier segments (6), which each have a carrier layer (10), to which a conductor structure adheres, and each of said hearing devices (2) having a connecting segment (8), which connects the two carrier segments (6) to each other, the connecting segment (8) being designed such that it can be bent and twisted,
**characterised in**
**that** the hearing device batch has
- a first embodiment of the hearing device (2) with a first custom-made housing and a first embodiment of the printed circuit board in a first installed state,
- a second embodiment of the hearing device having a second custom-made housing and the first embodiment of the printed circuit board in a second installed state,
- a third embodiment of the hearing device having a third custom-made housing and the first embodiment of the printed circuit board in a third installed state, wherein
the respective hearing device (2) is designed as a custom-made hearing device (2) and has a custom-made housing (16) with an outer shape respectively adapted to an ear of a wearer and with an individual configured inner space as a result of the outer shape adapted to the ear of the wearer as well as the respective printed circuit board (4), wherein the respective connecting segment (8) of the respective printed circuit board (4) is individually bent and/or individually twisted in itself, so that the respective printed circuit board (4) is individually adapted to the individually configured inner space, and wherein the printed circuit boards (4) are designed as standardized printed circuit boards (4), so that the printed circuit boards (4) of two custom-made hearing devices (2) differ only with regard to the bending and/or twisting of the respective connecting segment (8) .

2. Hearing device batch according to claim 1,
each of the hearing devices (2) being **characterised in**
**that** the connecting segment (8) is individually twisted in itself.

3. Hearing device batch according to claim 2,
each of the hearing devices (2) being **characterised in**
**that** the two carrier segments (6) are arranged next to each other as viewed along a connecting axis (V) in the extended state of the printed circuit board (4), and that the two carrier segments (6) can be rotated with respect to each other about the connecting axis (V) via the connecting segment (8) located in between them.

4. Hearing device batch according to claim 2 or 3,
each of the hearing devices (2) being **characterised in**
**that**, in the extended state of the printed circuit board (4), the two carrier segments (6) are arranged next to each other as viewed along a connecting axis (V), and that, as viewed transversely with respect to the connecting axis (V), the two carrier segments have a greater extent than the connecting segment (6) arranged between the two carrier segments (6).

5. Hearing device batch according to claim 4,
each of the hearing devices (2) being **characterised in**
**that** the extension of the connecting segment (8) transverse to the connecting axis (V) corresponds to less than 60 % of the extension of one of the carrier segments (6) transverse to the connecting axis (V).

6. Hearing device batch according to one of claims 2 to 5,
each of the hearing devices (2) being **characterised in**
**that** the carrier segments (6) carry electronic components (12).

7. Hearing device batch according to one of claims 2 to 6,
each of the hearing devices (2) being **characterised in**
**that** one of the carrier segments (6) carries an antenna (24) for radio waves, which protrudes from the carrier segment (6).

8. Hearing device batch according to one of claims 2 to 7,
each of the hearing devices (2) being **characterised in**
**that** one of the two carrier segments (6) of the printed circuit board (4) is attached to a faceplate (26).

9. Method of manufacturing a hearing device batch according to one of the preceding claims,
each of the hearing devices (2) being manufactured by
individually bending and/or twisting the connecting segment (8) in itself before or during the insertion of the printed circuit board (4) into the custom-made housing (16) in order to individually adapt the printed circuit board (4) to the individually configured inner space.

10. Method according to claim 9,
each of the hearing devices (2) being manufactured by
applying a shielding compound (22) to the printed circuit board (4) - after the printed circuit board (4) has been twisted in itself - at least in one section, which fixes the shape of the printed circuit board (4).

## Revendications

1. Lot d'appareils auditifs comprenant une pluralité d'appareils auditifs (2) de même type, chacun desdits appareils auditifs (2) comprenant une carte à circuits imprimés (4) avec deux segments de support (6), qui comprennent chacun une couche de support (10), à laquelle adhère une structure conductrice, et chacun desdits appareils auditifs (2) comprenant un segment de connexion (8), qui relie entre eux les deux segments de support (6), le segment de connexion (8) étant conçu de manière à pouvoir être plié et tordu,
**caractérisé en ce**
**que** le lot d'appareils auditifs comprend
- un premier modèle de l'appareil auditif (2) comprenant un premier boîtier fabriqué sur mesure et un premier modèle de la carte à circuits imprimés dans un premier état de montage,
- un deuxième modèle de l'appareil auditif comprenant un deuxième boîtier sur mesure et le première modèle de la carte à circuits imprimés dans un deuxième état de montage,
- un troisième modèle de l'appareil auditif comprenant un troisième boîtier fabriqué sur mesure et le premier modèle de la carte à circuits imprimés dans un troisième état de montage, dans lequel
l'appareil auditif respectif (2) est réalisé sous forme d'appareil auditif (2) fabriqué sur mesure et comprend un boîtier (16) fabriqué sur mesure avec une forme extérieure adaptée respectivement à une oreille d'un porteur ainsi qu'avec un espace intérieur configuré individuellement comme conséquence de la forme extérieure adaptée à l'oreille du porteur ainsi que la carte à circuits imprimés respective (4), le segment de connexion respectif (8) de la carte à circuits imprimés respective (4) étant plié individuellement et/ou tordu individuellement sur lui-même, de sorte que la carte à circuits imprimés (4) respective est adaptée individuellement à l'espace intérieur configuré individuellement, et les cartes à circuits imprimés (4) étant conçues comme des cartes à circuits imprimés (4) standardisées, de sorte que les cartes à circuits imprimés (4) de deux appareils auditifs (2) fabriqués sur mesure se distinguent uniquement en ce qui concerne le pliage et/ou la torsion du segment de connexion (8) respectif.

2. Charge d'appareils auditifs selon la revendication 1,
chacun desdits appareils auditifs (2) étant **caractérisé en ce**
**que** le segment de connexion (8) est tordu individuellement sur lui-même.

3. Charge d'appareils auditifs selon la revendication 2,
chacun desdits appareils auditifs (2) étant **caractérisé en ce**
**que** les deux segments de support (6) sont disposés l'un à côté de l'autre, vus le long d'un axe de connexion (V), lorsque la carte à circuits imprimés (4) est à l'état étiré, et que les deux segments de support (6) peuvent être tordus l'un par rapport à l'autre autour de l'axe de connexion (V) par l'intermédiaire du segment de connexion (8) situé entre eux.

4. Charge d'appareils auditifs selon la revendication 2 ou 3,
chacun desdits appareils auditifs (2) étant **caractérisé en ce**
**que** les deux segments de support (6) sont disposés l'un à côté de l'autre, vus le long d'un axe de connexion (V), lorsque la carte à circuits imprimés (4) est à l'état étiré, et que les deux segments de support comprennent, vus transversalement à l'axe de connexion (V), une extension plus grande que le segment de connexion (6) disposé entre les deux segments de support (6).

5. Charge d'appareils auditifs selon la revendication 4,
chacun desdits appareils auditifs (2) étant **caractérisé en ce**
**que** l'extension du segment de connexion (8) transversalement à l'axe de connexion (V) correspond à moins de 60 % de l'extension de l'un des segments de support (6) transversalement à l'axe de connexion (V).

6. Charge d'appareils auditifs selon l'une des revendications 2 à 5,
chacun desdits appareils auditifs (2) étant **caractérisé en ce**
**que** les segments de support (6) portent des composants électroniques (12).

7. Charge d'appareils auditifs selon l'une des revendications 2 à 6,
chacun desdits appareils auditifs (2) étant **caractérisé en ce**
**que** l'un des segments de support (6) porte une antenne (24) pour ondes radio, qui fait saillie du segment de support (6).

8. Charge d'appareils auditifs selon l'une des revendications 2 à 7,
chacun desdits appareils auditifs (2) étant **caractérisé en ce**
**que** l'un des deux segments de support (6) de la carte à circuits imprimés (4) est fixé à une plaque frontale (26).

9. Procédé de fabrication d'un lot d'appareils auditifs selon l'une des revendications précédentes,
chacun des appareils auditifs (2) étant fabriqué en
pliant individuellement et/ou tordant sur lui-même le segment de connexion (8) avant ou pendant l'insertion de la carte à circuits imprimés (4) dans le boîtier (16) fabriqué sur mesure, afin d'adapter individuellement la carte à circuits imprimés (4) à l'espace intérieur configuré individuellement.

10. Procédé selon la revendication 9,
chacun des appareils auditifs (2) étant fabriqué en
appliquant sur la carte à circuits imprimés (4), après que celle-ci a été tordue sur elle-même, au moins dans une section, une masse de blindage (22), qui fixe la forme de la carte à circuits imprimés (4).
